# EUROPEAN PATENT APPLICATION

(11) **EP 1 463 083 A2**
(43) Date of publication of application: **29.09.2004**
(21) Application number: 04251616.1
(22) Date of filing: 20.03.2004
(51) Int. Cl.: H01H 85/046

(54) **Fuse arrangement**

(30) Priority: 29.03.2003 GB 0307306
(71) Applicant: Goodrich Control Systems Ltd, Solihull, West Midlands B90 4LA (GB)
(72) Inventor: Hill, Robin David, Shirley, Solihull B90 2HJ (GB)
(74) Representative: Bailey, Richard Alan

(57) **Abstract**

A fuse arrangement comprises a circuit board (11) having a terminal region (12) and a conductive track (10) electrically connected to the terminal region (12), the conductive track including a fuse region (14) of reduced cross-sectional area, the fuse region (14) being shaped to cause a deviation in the current flow through the fuse region (14), and wherein the part (16) of the conductive track (10) between the terminal region (12) and the fuse region (14) is free from sharp deviations.

## Description

This invention relates to a fuse arrangement, and in particular to a fuse arrangement suitable for incorporation on the surface of a circuit board.

Electronic engine controllers for aerospace applications typically take the form of complex, multi-layer circuit boards carrying a number of components. Due to the complexity and cost of these boards it is important to protect them from damage. One potential cause of damage to components carried by these boards is the application of transient high voltages to the input or output lines of the boards, for example as may occur in the event of a lightning strike. One technique for guarding against such damage is to provide suppressors which are designed to protect circuitry connected to the associated input or output line by clamping the line at a safe voltage in the event of the application of a transient high voltage, the excess current being conducted to ground. These devices can be provided upon a separate circuit board which can be replaced relatively cheaply in the event of damage.

Another potential cause of damage is due to short circuits occurring between circuits which, under normal operation, are unrelated. For example if a high voltage power supply line and a line connected to a low voltage sensor become shorted to one another it will be appreciated that there is a significant risk of damage to the associated engine controller. Although suppressors are used successfully to guard against damage due to transient voltages, they are not suitable for preventing damage due to the application of continuous voltages as may occur in the event of a short circuit, and will typically fail resulting in the excess voltage being applied to a vulnerable circuit of the engine controller causing damage thereto. Once one circuit has become damaged, there is a risk of damage propagating to other circuits, particularly on high density boards such as those used in electronic engine controllers.

It is known to provide a conventional fuse in series with a suppressor so that the fuse blows before the suppressor fails open circuit, under continuous short circuit conditions. However, the use of such fuses is undesirable as they tend to be of large dimensions and hence are difficult to accommodate in areas of high track density, particularly adjacent the board's connectors. Further, many aerospace applications require the components used to operate at temperatures of up to 125 °C. Most commercially available fuses cannot be used reliably as their current rating falls to an unusably low value at elevated temperatures.

It is known to form a reduced thickness fuse portion in the conductive track provided on the surface of a circuit board. However, it has been found that, depending upon the circuit or track layout, the track may fail other than in the fuse portion upon the application of an excess voltage. This is undesirable since failure may occur at positions which could cause shorts to other circuits or on tracks within the board which could cause a fire.

It is an object of the invention to provide a fuse arrangement in which the disadvantages mentioned hereinbefore are overcome or of reduced effect.

According to the present invention there is provided a fuse arrangement comprising a circuit board having a terminal region and a conductive track electrically connected to the terminal region, the conductive track including a fuse region of reduced cross-sectional area, the fuse region being shaped to cause a deviation in the current flow through the fuse region, and wherein the part of the conductive track between the terminal region and the fuse region is free from sharp deviations.

It has been found that the provision of the fuse region shaped to form such a deviation in the current flow results in the formation of a point of high current density which is likely to fail first in the event of the application of an excess voltage, particularly if no sharp deviations to current flow are formed in the part of the track between the terminal and the fuse region.

The fuse region preferably comprises first and second parts which are angled to one another to form the deviation. Preferably the first and second parts are angled to one another by an angle of 70° to 110°, more preferably about 90°. It has been found that such an arrangement is of good reliability.

The fuse arrangement may further comprise a clamping device electrically connected to the track. The clamping device may take the form of, for example, a suppressor, a zener diode or a ground link.

The invention will further be described, by way of example, with reference to the accompanying drawings, in which:
Figure 1 is a diagrammatic view of a fuse arrangement in accordance with an embodiment of the invention;
Figure 2 to 4 illustrate modifications to the arrangement of Figure 1; and
Figures 5 and 6 illustrate further modifications.

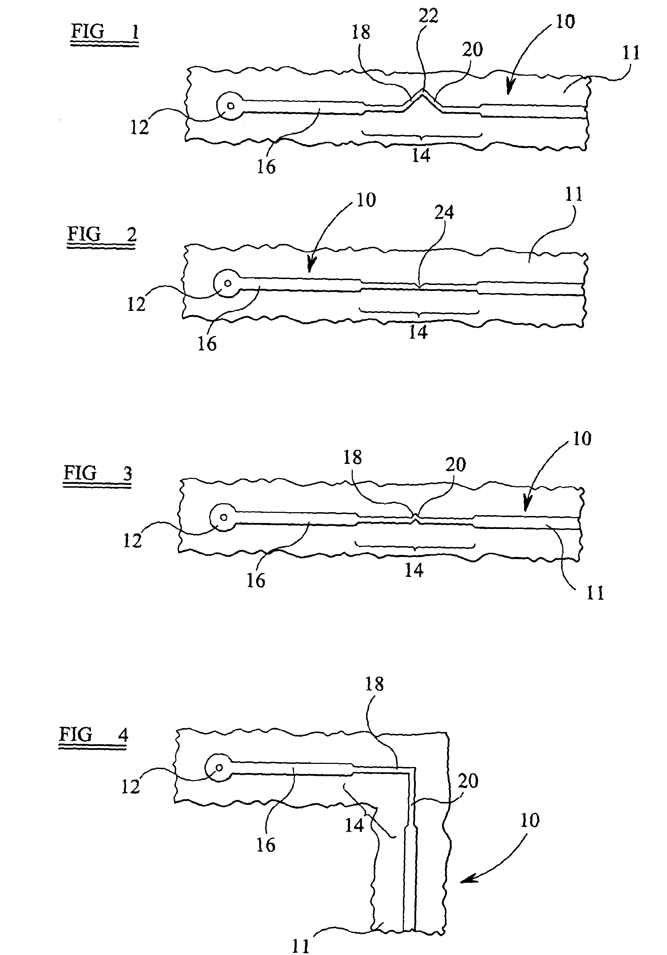

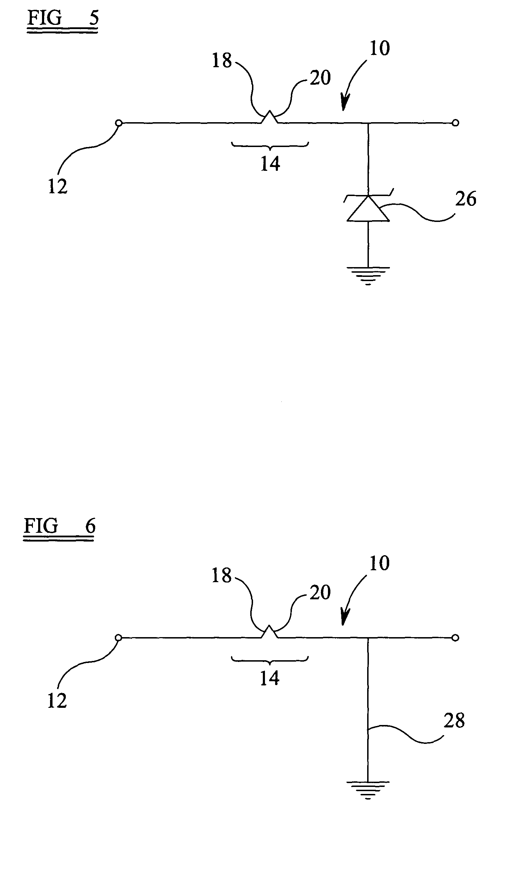

The fuse arrangement illustrated in Figure 1 comprises a copper or other conductive material track 10 formed on the surface of a circuit board 11, the track 10 being electrically connected to a terminal 12 of any suitable form, and to the components of a circuit. The track 10 may also be connected to a clamping device, for example in the form of a suppressor 26 (as shown in the modification illustrated in Figure 5), a zener diode, or a ground short 28 (as illustrated in the modification of Figure 6). As shown in Figure 1, the track 10 includes a region of reduced width, and hence reduced cross-sectional area, which will hereinafter be referred to as the fuse region 14. The fuse region 14 is connected to the terminal 12 by a portion 16 of the track 10 which is free from deviations. The fuse region 14 is shaped to form a significant deviation in the flow of current along the track 10. The deviation is formed by providing the fuse region 14 with a first part 18 and a second part 20 which are angled to one another to form therebetween a sharp deviation to the flow of current along the track 10. As the portion 16 is free of deviations, the deviation formed in the fuse region 14 is the closest deviation to the terminal 12.

It is thought that the provision of the sharp deviation in the direction of current flow results in the formation of a point 22 of high current density, and the formation of such a point acts as a failure point in the event of the application of an excess voltage to the track 10 at which failure will occur first. Once the material at the point 22 has become molten, the adjacent part of the track will rapidly melt causing a break in the track 10.

In the arrangement illustrated in Figure 1, the first and second parts 18, 20 of the fuse region 14 are angled to one another by an angle of 90°. It is thought that the use of such an angle is advantageous in that it provides an optimum balance between the formation of a point of high current density and minimises the amount of track material which must be deformed during rapid heating under overload conditions to cause the fuse to blow. Although it is thought that an angle of approximately 90°provides the optimum balance between these factors, it will be appreciated that the invention is not restricted to the use of this angle, and that the invention covers the use of other arrangements using larger or smaller sharp deviations in the current flow through the fuse region, although they may operate less predictably. For example, the angle may fall within the range 70° to 110°.

Figures 2, 3 and 4 illustrate modifications to the arrangement shown in Figure 1. In the arrangement of Figure 2, the fuse region 14 is formed with a V-shaped indent 24 which forms a deviation in the flow of at least some of the current flowing along the track 10, again resulting in the formation of a point 22 of high current density. The arrangement of Figure 3 is similar to that of Figure 1, but the first and second parts 18, 20 of the fuse region 14 are of reduced dimensions with the result that only part of the current flow along the fuse region 14 is deviated. Again, such an arrangement results in the formation of a point 22 of high current density. As the arrangements of Figures 2 and 3 do not form a deviation across the full width of the track 10, it is thought that the point of high current density will be of lower concentration than that achieved in the arrangement of Figure 1.

The arrangement of Figure 4 is similar to that of Figure 1, but is suitable for use where the track 10 is made up of parts which are not aligned with one another. In this arrangement, as with that of Figure 1, the layout of the fuse region 14 is such as to form a significant deviation, thus the point 22 of high current density is well defined.

Although the fuse arrangements described herein are suitable for use in aerospace applications, and in particular for use in protecting the circuits of an electronic engine controller, it will be appreciated that the fuse arrangements may be used in a number of other applications.

## Claims

1. A fuse arrangement comprising a circuit board (11) having a terminal region (12) and a conductive track (10) electrically connected to the terminal region (12), the conductive track (10) including a fuse region (14) of reduced cross-sectional area, **characterised in that** the fuse region (14) is shaped to cause a deviation in the current flow through the fuse region (14), and wherein a part (16) of the conductive track (10) extending between the terminal region (12) and the fuse region (14) is free from sharp deviations.

2. An arrangement according to Claim 1, wherein the fuse region (14) comprises first and second parts (18, 20) which are angled to one another to form the deviation.

3. An arrangement according to Claim 2, wherein the first and second parts (18, 20) are angled to one another by an angle falling within the range of 70° to 110°.

4. An arrangement according to Claim 3, wherein the first and second parts (18, 20) are angled to one another by an angle of about 90°.

5. An arrangement according to Claim 1, wherein a sharp indent (24) is formed in the fuse region (14) to form the deviation to current flow.

6. An arrangement according to any one of the preceding claims, further comprising a clamping device electrically connected to the track.

7. An arrangement according to Claim 6, wherein the clamping device comprises one of a zener diode (26), a ground link (28) and a suppressor.
